# DEMANDE DE BREVET EUROPEEN

(11) **EP 4 738 704 A1**
(43) Date de publication de la demande: **06.05.2026**
(21) Numéro de dépôt: 25209809.0
(22) Date de dépôt: 20.10.2025
(51) Int. Cl.: H03K 3/03

(54) **OSCILLATEUR EN ANNEAU**

(30) Priorité: 31.10.2024 FR 2411946
(71) Demandeur: STMicroelectronics International N.V., 1228 Plan-les-Ouates, Geneva (CH)
(72) Inventeur: BERGER, Dominique, 38500 Voiron (FR)
(74) Mandataire: Cabinet Beaumont

(57) **Abrégé**

La présente description concerne un circuit de commande (120) d'une fréquence d'un signal de sortie (Out100) d'un oscillateur en anneau (110) comprenant :
- un premier transistor (T121) d'un premier type adapté à recevoir une tension de commande (Vctrl120) sur sa borne de commande et adapté à fournir un premier courant de commande (I121)de fréquence sur une première borne de conduction ;
- un deuxième transistor (T122) d'un deuxième type, différent du premier type, adapté à recevoir ladite tension de commande (Vctrl120) sur sa borne de commande, et adapté à fournir un deuxième courant (I122) à une deuxième borne de conduction dudit premier transistor (T121).

## Description

### Domaine technique

La présente description concerne de façon générale les systèmes et dispositifs électroniques, et plus particulièrement les circuits de commande de systèmes et dispositifs électroniques. La présente description se rapporte plus précisément à un oscillateur en anneau et à son circuit de commande de fréquence.

### Technique antérieure

Il existe une multitude de circuits permettant de générer des signaux, et en particulier permettant de générer des signaux périodiques.

Les oscillateurs en anneaux sont des circuits bien connus permettant de générer des signaux périodiques, qui sont souvent utilisés pour générer des signaux d'horloge.

Il serait souhaitable de pouvoir améliorer, au moins en partie, certains aspects des circuits de génération de signaux connus, et en particulier, certains aspects des circuits de commande connus des circuits de génération de signaux.

### Résumé de l'invention

Il existe un besoin pour un circuit de commande de la fréquence d'un signal fourni par un oscillateur en anneau plus précis.

Il existe un besoin pour un procédé de commande de la fréquence d'un signal fourni par un oscillateur en anneau plus précis.

Il existe un besoin pour un oscillateur en anneau plus précis.

Un mode de réalisation pallie tout ou partie des inconvénients des circuits de commande de fréquence connus d'un oscillateur en anneau.

Un mode de réalisation pallie tout ou partie des inconvénients des procédés de commande de fréquence connus d'un oscillateur en anneau.

Un mode de réalisation pallie tout ou partie des inconvénients des oscillateurs en anneau.

Un mode de réalisation prévoit l'ajout, au courant de commande fourni par ledit circuit de commande, d'un courant inversement proportionnel à une tension de commande de fréquence du circuit de commande.

Un mode de réalisation prévoit un circuit de commande d'une fréquence d'un signal de sortie d'un oscillateur en anneau comprenant :
- un premier transistor d'un premier type adapté à recevoir une tension de commande sur sa borne de commande et adapté à fournir un premier courant de commande de fréquence sur une première borne de conduction ;
- un deuxième transistor d'un deuxième type, différent du premier type, adapté à recevoir ladite tension de commande sur sa borne de commande, et adapté à fournir un deuxième courant à une deuxième borne de conduction dudit premier transistor.

Un autre mode de réalisation prévoit un procédé de commande d'une fréquence d'un signal de sortie d'un oscillateur en anneau utilisant un circuit comprenant :
- un premier transistor d'un premier type adapté à recevoir une tension de commande sur sa borne de commande et adapté à fournir un premier courant de commande de fréquence sur une première borne de conduction ;
- un deuxième transistor d'un deuxième type, différent du premier type, adapté à recevoir ladite tension de commande sur sa borne de commande, et adapté à fournir un deuxième courant à une deuxième borne de conduction dudit premier transistor.

Selon un mode de réalisation, lesdits premier et deuxième transistors sont des transistors MOS.

Selon un mode de réalisation :
- ledit premier transistor est un transistor de type NMOS ; et
- ledit deuxième transistor est un transistor de type PMOS.

Selon un mode de réalisation, lesdits premier et deuxième transistors sont des transistors bipolaires.

Selon un mode de réalisation :
- ledit premier transistor est un transistor de type NPN ; et
- ledit deuxième transistor est un transistor de type PNP.

Selon un mode de réalisation, ledit deuxième transistor est adapté à fournir ledit deuxième courant par l'intermédiaire d'un miroir de courant.

Selon un mode de réalisation, ladite deuxième borne de conduction dudit premier transistor est reliée à une résistance.

Un autre mode de réalisation prévoit un oscillateur en anneau comprenant un circuit décrit précédemment.

Un autre mode de réalisation prévoit un dispositif électronique comprenant un oscillateur décrit précédemment.

Selon un mode de réalisation, le dispositif est une boucle à verrouillage de phase.

Un autre mode de réalisation prévoit un système électronique comprenant un dispositif décrit précédemment.

Selon un mode de réalisation, le système est un contrôleur, un microcontrôleur, un processeur, ou un microprocesseur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un oscillateur en anneau et de son circuit de commande de fréquence ;
la figure 2 représente des courbes illustrant le fonctionnement du circuit de commande de la figure 1 ;
la figure 3 représente un dispositif électronique utilisant le mode de réalisation de la figure 1 ; et
la figure 4 représente un système électronique utilisant le mode de réalisation de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

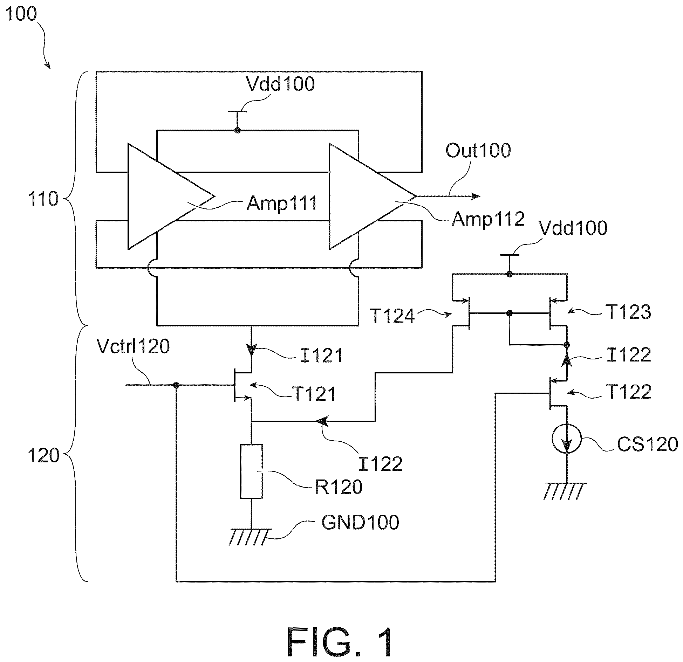

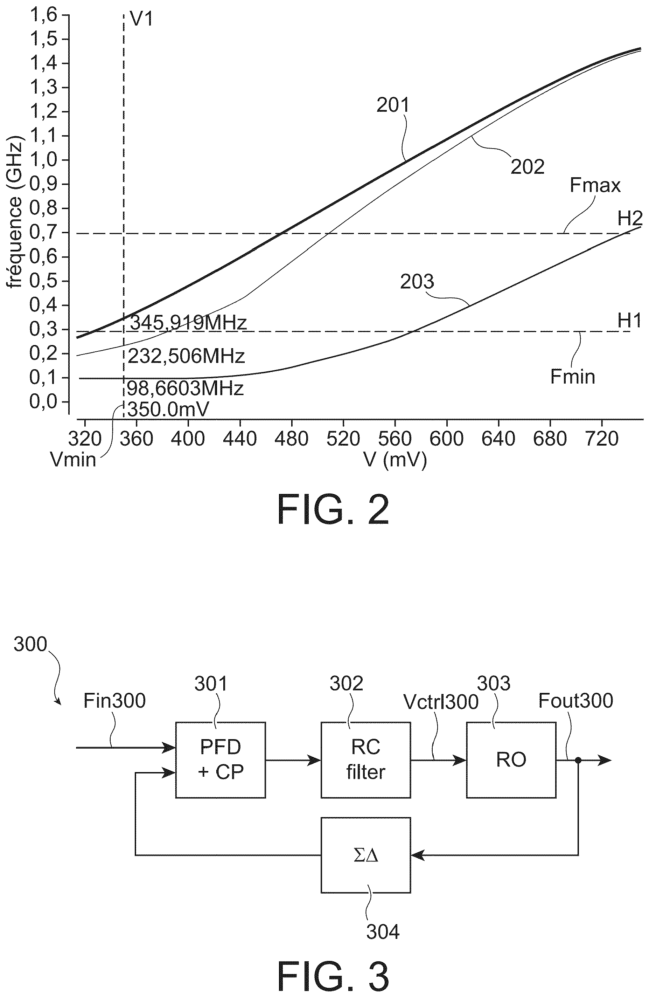

Les modes de réalisation décrits ci-après concernent l'ajustement d'une commande en fréquence d'un oscillateur en anneau. Plus particulièrement, ces modes de réalisation utilise l'ajout d'un courant inversement proportionnel à une tension de commande à une borne d'un transistor fournissant un courant de commande de fréquence. Ces modes de réalisation sont décrits en relation avec les figures 1 et 2.

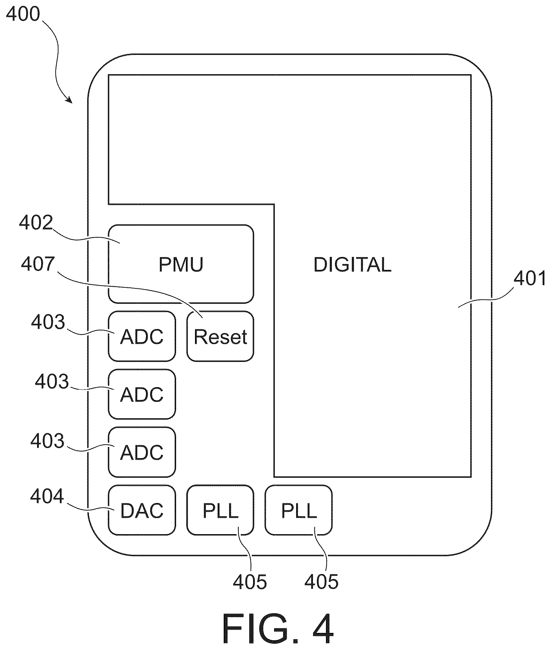

De plus, les modes de réalisation décrits ci-après sont tout particulièrement adaptés à être utilisés dans un boucle à verrouillage de phase (Phase-Locked Loop, PLL), par exemple une boucle à verrouillage de phase utilisée dans un microcontrôleur. Ces applications sont décrites plus en détails en relation avec les figures 3 et 4.

De plus, les modes de réalisation décrits ci-dessus sont particulièrement adaptés pour être utilisés dans tout type de marchés industriels où l'utilisation d'un oscillateur en anneau est nécessaire. Plus particulièrement, un tel oscillateur en anneau peut être destiné à :
- l'industrie automobile, par exemple dans le domaine de l'électrification automobile ou dans le domaine des systèmes avancés d'aide à la conduite (Advanced Driver Assistance Systems - ADAS) ;
- le secteur industriel, par exemple dans le domaine de l'énergie verte, dans le domaine de l'électrification des infrastructures, de l'internet des objets (Internet of Things
- IoT) et des maisons intelligentes (SmartHome), où la consommation d'électricité et d'énergie et l'échange de données sont des éléments clés ;
- l'industrie de l'électronique personnelle, par exemple dans le domaine de la téléphonie mobile et de l'internet des objets (Internet of Things - IoT), ainsi que dans le domaine des interfaces haut débit ; et
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

La figure 1 représente un mode de réalisation d'un circuit électronique 100 de génération d'un signal périodique.

Selon un mode de réalisation, le circuit 100 est un oscillateur en anneau (Ring Oscillator, RO) accompagné de son circuit de commande de la fréquence de son signal de sortie Out100. Dit autrement, le circuit 100 comprend :
- un oscillateur en anneau 110 ; et
- un circuit de commande 120 de la fréquence d'un signal de sortie Out100 de l'oscillateur en anneau 110.

Selon un mode de réalisation, l'oscillateur en anneau 110 est adapté à fournir le signal de sortie Out100. Ce signal Out100 est un signal périodique, par exemple un signal pouvant servir de signal d'horloge. Selon un mode de réalisation, la fréquence du signal Out100 est réglée, fixée, modifiée, ou commandée via un courant de commande I121 fourni par le circuit de commande 120.

Selon un exemple, l'oscillateur en anneau 110 comprend au moins deux amplificateurs Amp111 et Amp112 à entrée et sortie différentielles. Les sorties de l'amplificateur Amp111 sont reliées, de préférence connectées, aux entrées de l'amplificateur Amp112. Les sorties de l'amplificateur Amp112 sont reliées, de préférence connectées, aux entrées de l'amplificateur Amp111. Selon un exemple, les amplificateurs Amp111 et Amp112 sont adaptés à être alimentés par une tension d'alimentation Vdd100. Selon un exemple, les amplificateurs Amp111 et Amp112 sont adaptés à être recevoir le courant de commande I121 sur leurs bornes de commande. D'autres structures d'oscillateurs en anneau peuvent être utilisées ici et sont à la portée de la personne du métier. En particulier, tout oscillateur en anneau pouvant recevoir une commande de fréquence en courant est compatible avec le circuit de commande 120.

Selon un mode de réalisation, le circuit de commande 120 comprend un transistor T121 d'un premier type et une résistance R120. Une première borne de conduction du transistor T121 est adaptée à fournir le courant de commande I121, et une deuxième borne de conduction du transistor T121 est reliée, de préférence connectée, à une première borne de la résistance R120. Une deuxième borne de conduction de la résistance R120 est reliée, de préférence connectée, à un noeud adapté à fournir une tension de référence GND100, par exemple la masse. Une borne de commande du transistor T121 est adapté à recevoir une tension de commande Vctrl120.

Selon un mode de réalisation, le circuit de commande 120 comprend, en outre, une source de courant CS120 et un transistor T122 d'un deuxième type. Une borne de référence de la source de courant CS120 est reliée, de préférence connectée, au noeud fournissant la tension de référence GND100. Une borne de sortie de la source de courant CS120 est reliée, de préférence connectée, à une première borne de conduction du transistor T122. Une deuxième borne de conduction du transistor T122 est reliée au noeud milieu entre le transistor T121 et la résistance R120 via un moyen de transmission détaillé ci-après et fournit un courant I122. Une borne de commande du transistor T122 est adaptée à recevoir la tension de commande Vctrl120.

Selon un mode de réalisation, les transistors T121 et T122 sont des transistors de même technologie mais de types différents. Dit autrement, le transistor T121 est d'un premier type et le transistor T122 est d'un deuxième type différent du premier type. Plus particulièrement, les transistors T121 et T122 réagissent de manière opposée à la tension de commande Vctrl120. Encore plus particulièrement, le transistor T121 devient de plus en plus conducteur en fonction d'une première variation de la tension de commande Vctrl120, alors que pour cette même variation, le transistor T122 devient de moins en moins conducteur, et inversement.

Selon un mode de réalisation, le circuit de commande 120 comprend, en outre, un moyen de transmission du courant I122, ou moyen de recopie de courant, délivré par le transistor T122 au noeud milieu entre le transistor T121 et la résistance R120. Selon un exemple, ce moyen est un montage miroir de courant, ou miroir de courant, comprenant deux transistors T123 et T124. Selon un exemple, une première borne de conduction du transistor T123 est reliée, de préférence connectée, à la deuxième borne de conduction du transistor T122 et aux bornes de commande des transistors T123 et T124. Une première borne de conduction du transistor T124 est reliée, de préférence connectée, au noeud milieu entre le transistor T121 et la résistance R120. Les deuxièmes bornes de conduction des transistors T123 et T124 sont reliées, de préférence connectées, à la borne fournissant la tension d'alimentation Vdd100.

Selon un premier mode de réalisation, les transistors T121 et T122, ainsi que, selon un exemple, les transistors T123 et T124 sont tous des transistors à effet de champ à grille métal-oxyde (metal-oxide-semiconductor field-effect transistor), ou transistor de technologie MOSFET, ou transistor MOS. De plus, le transistor T121 est un transistor MOS à canal N, ou transistor MOS de type N, ou transistor NMOS. De plus, le transistor T122 est un transistor MOS à canal P, ou transistor MOS de type P, ou transistor PMOS. Selon un exemple, les transistors T123 et T124 sont des transistors de type PMOS.

Selon un deuxième mode de réalisation, les transistors T121 et T122, ainsi que, selon un exemple, les transistors T123 et T124 sont tous des transistors de technologie bipolaire. De plus, le transistor T121 est un transistor de type NPN, et le transistor T122 est un transistor de type PNP. Selon un exemple, les transistors T123 et T124 sont des transistors de type PNP.

Selon un mode de réalisation, un procédé de commande de la fréquence du signal de sortie Out100 de l'oscillateur en anneau 110 est le suivant. Une tension de commande est appliquée au circuit de commande 120, cette tension permet de rendre le transistor T121 conducteur et de rendre le transistor T122 non conducteur, ou inversement, et plus particulièrement, d'augmenter la valeur du courant I121 fourni par le transistor T121 et de réduire la valeur du courant I122 fourni par le transistor T122, ou inversement.

La figure 2 est un graphique comprenant des courbes illustrant le fonctionnement du circuit 100 décrit en relation avec la figure 1.

Le graphique de la figure 2 comprend, plus particulièrement :
- une courbe 201 illustrant une simulation de l'évolution de la fréquence d'un signal de sortie d'un circuit similaire au circuit 100 de la figure 1 mais ne comprenant pas de transistor T122, de source de courant CS120 et de moyen de transmission de courant, en fonction de la valeur de la tension de commande Vctrl120, dans le cas où le circuit 100 présente un gain de 125 degrés et d'une mise en oeuvre rapide ;
- une courbe 202 illustrant l'évolution de la fréquence du signal de sortie Out100 du circuit 100 de la figure 1 en fonction de la valeur de la tension de commande Vctrl120, , dans le cas où le circuit 100 présente un gain à 125 degré et d'une mise en oeuvre rapide ; et
- une courbe 203 illustrant l'évolution de la fréquence du signal de sortie Out100 du circuit 100 de la figure 1 en fonction de la valeur de la tension de commande Vctrl120, dans le cas où le circuit 100 présente un gain à -40 degré et d'une mise en oeuvre lente.

Sont aussi représentées en figure 2, une fréquence maximale Fmax, une fréquence minimale Fmin, et une tension minimale Vmin.

L'avantage de l'ajout du courant I122, c'est-à-dire de l'utilisation du transistor I122, de la source de courant CS120 et du moyen de transmission, est de permettre au circuit 100 d'être capable de fournir un signal de sortie ayant une fréquence comprise entre les fréquences Fmin et Fmax dès que la tension de commande Vctrl120 est supérieure à la tension Vmin lorsque le gain du circuit est adapté pour un cas de mise en oeuvre rapide à une température haute. On remarque que ce résultat n'est pas atteint lorsque le courant I122 n'est pas ajouté.

La figure 3 représente, schématiquement et sous forme de blocs, un mode de réalisation d'un dispositif électronique 300 utilisant le circuit 100 décrit en relation avec la figure 1.

Selon un exemple, le dispositif électronique 300 est une boucle à verrouillage de phase (Phase-locked loop, PLL). Selon un exemple particulier, le dispositif 300 est une boucle à verrouillage de phase adapté à recevoir, en entrée, un signal à une première fréquence Fin300 et à fournir, en sortie, un signal à une deuxième fréquence Fout300 qui est un multiple de la première fréquence Fin300.

Pour cela, le dispositif 300 peut comprendre :
- un circuit 301 (PFD + Constance Prost-Boucle) d'entrée ;
- un circuit 302 (RC filter) de filtrage ;
- un circuit 303 (RO) du type du circuit 100 décrit en relation avec la figure 1 ; et
- un circuit 304.

Le circuit 301 est adapté à recevoir le signal d'entrée de fréquence Fin300. Selon un exemple, le circuit 301 comprend un circuit de détection de fréquence et de phase (Phase-frequency detector, PFD), et une pompe de charge (Charge Pump, CP).

Le circuit 302 (RC filtrage) est adapté à recevoir un signal de sortie du circuit 301, et à fournir, en sortie une tension de commande Vctrl300 à destination du circuit 303. Selon un exemple, le circuit 302 est un circuit de filtrage de type RC, c'est-à-dire de type résistance-condensateur.

Le circuit 303 (RO) est du type du circuit 100 décrit en relation avec la figure 1. Le circuit 303 est adapté à recevoir la tension de commande Vctrl300 de la part du circuit 302 et à fournir le signal de sortie de fréquence Fout300.

Le circuit 304 est un circuit de rétroaction adapté à recevoir le signal de sortie de fréquence Fout300 et à le fournir en entrée du circuit 301.

D'autres applications du circuit 100 décrit en relation avec la figure 1 sont à la portée de la personne du métier.

La figure 4 représente, schématiquement et sous forme de blocs, un mode de réalisation d'un système électronique 400 utilisant le circuit 300 décrit en relation avec la figure 3.

Selon un exemple, le système 400 est un système électronique complexe, comme un contrôleur, un microcontrôleur, un processeur, ou un microprocesseur. Selon un exemple particulier, le système 400 est microcontrôleur.

Selon un exemple, le système 400 comprend :
- un ou plusieurs circuits digitaux 401 (DIGITAL) ;
- au moins une unité de gestion d'alimentation 402 (PMU) ;
- un ou plusieurs circuits de conversion analogique-numérique 403 (ADC) ;
- un ou plusieurs circuits de conversion numérique analogique 404 (DAC) ;
- une ou plusieurs boucles à verrouillage de phase 405 (PLL) ; et
- au moins un circuit de réinitialisation 407 (Reset).

D'autres applications du dispositif 300 décrit en relation avec la figure 3 sont à la portée de la personne du métier.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit de commande (120) d'une fréquence d'un signal de sortie (Out100) d'un oscillateur en anneau (110) comprenant :
- un premier transistor (T121) d'un premier type adapté à recevoir une tension de commande (Vctrl120) sur sa borne de commande et adapté à fournir un premier courant de commande (I121)de fréquence sur une première borne de conduction ;
- un deuxième transistor (T122) d'un deuxième type, différent du premier type, adapté à recevoir ladite tension de commande (Vctrl120) sur sa borne de commande, et adapté à fournir un deuxième courant (I122) à une deuxième borne de conduction dudit premier transistor (T121).

2. Procédé de commande d'une fréquence d'un signal de sortie d'un oscillateur en anneau utilisant un circuit comprenant :
- un premier transistor (T121) d'un premier type adapté à recevoir une tension de commande (Vctrl120) sur sa borne de commande et adapté à fournir un premier courant de commande (I121) de fréquence sur une première borne de conduction ;
- un deuxième transistor (T122) d'un deuxième type, différent du premier type, adapté à recevoir ladite tension de commande (Vctrl120) sur sa borne de commande, et adapté à fournir un deuxième courant (I122) à une deuxième borne de conduction dudit premier transistor (T121).

3. Circuit selon la revendication 1, ou procédé selon la revendication 2, dans lequel lesdits premier et deuxième transistors (T121, T122) sont des transistors MOS.

4. Circuit ou procédé selon la revendication 3, dans lequel :
- ledit premier transistor (T121) est un transistor de type NMOS ; et
- ledit deuxième transistor (T122) est un transistor de type PMOS.

5. Circuit selon la revendication 1, ou procédé selon la revendication 2, dans lequel lesdits premier et deuxième transistors (T121, T122) sont des transistors bipolaires.

6. Circuit ou procédé selon la revendication 5, dans lequel :
- ledit premier transistor (T121) est un transistor de type NPN ; et
- ledit deuxième transistor (T122) est un transistor de type PNP.

7. Circuit selon l'une quelconque des revendications 1, 3 à 6, ou procédé selon l'une quelconque des revendications 2 à 6, dans lequel ledit deuxième transistor (T122) est adapté à fournir ledit deuxième courant par l'intermédiaire d'un miroir de courant.

8. Circuit selon l'une quelconque des revendications 1, 3 à 7, ou procédé selon l'une quelconque des revendications 2 à 7, dans lequel ladite deuxième borne de conduction dudit premier transistor (T121) est reliée à une résistance (R120) .

9. Oscillateur en anneau (100) comprenant un circuit selon l'une quelconque des revendications 1, 3 à 8.

10. Dispositif électronique (300) comprenant un oscillateur selon la revendication 9.

11. Dispositif selon la revendication 10, étant une boucle à verrouillage de phase.

12. Système électronique (400) comprenant un dispositif selon la revendication 10 ou 11.

13. Système selon la revendication 12, étant un contrôleur, un microcontrôleur, un processeur, ou un microprocesseur.
